# EUROPEAN PATENT SPECIFICATION

(11) **EP 4 459 968 B1**
(45) Date of publication and mention of the grant of the patent: **11.02.2026**
(21) Application number: 23841815.6
(22) Date of filing: 11.04.2023
(51) Int. Cl.: H04M 1/02, F16C 11/04, G06F 1/16, H05K 1/18

(54) **FOLDABLE ELECTRONIC DEVICE WITH SHAFT COVER ASSEMBLY**
FALTBARE ELEKTRONISCHE VORRICHTUNG MIT SCHACHTABDECKUNGSANORDNUNG
DISPOSITIF ÉLECTRONIQUE PLIABLE AVEC ENSEMBLE COUVERCLE D'ARBRE

(30) Priority: 22.07.2022 CN 202210866536
(43) Date of publication of application: 06.11.2024
(73) Proprietor: Honor Device Co., Ltd., Shenzhen, Guangdong 518040 (CN)
(72) Inventor: WANG, Wenhao, Shenzhen, Guangdong 518040 (CN); ZHANG, Yihe, Shenzhen, Guangdong 518040 (CN); YANG, Xiujuan, Shenzhen, Guangdong 518040 (CN); HAN, Ye, Shenzhen, Guangdong 518040 (CN)
(74) Representative: MERH-IP Matias Erny Reichl Hoffmann Patentanwälte PartG mbB
(86) International application number: PCT/CN2023/087551
(87) International publication number: WO 2024/016742

(56) References cited:
- CN-A- 113 286 023
- CN-A- 113 890 910
- CN-A- 113 923 279
- CN-A- 114 205 430
- CN-A- 114 449 067
- CN-U- 216 743 503
- US-A1- 2018 324 964
- US-A1- 2021 274 028
- US-B1- 6 831 229

## Description

### TECHNICAL FIELD

Embodiments of this application relate to the field of terminal technologies, and in particular, to a foldable electronic device comprising a shaft cover assembly.

### BACKGROUND

Foldable electronic devices such as mobile phones and computers have become inseparable from our lives, are seen everywhere in our lives, and greatly improve living standards of people. With rapid development of communication device technologies, a screen display effect of a mobile terminal such as a mobile phone attracts increasingly more attention. However, a volume of the mobile phone restricts expansion of a screen size.

In a related technology, to implement a large screen area on a small electronic device, a foldable structure may be used for the electronic device. Specifically, a foldable electronic device generally includes a primary device part, a secondary device part, and a rotating shaft assembly. The primary device part and the secondary device part are rotatably connected to each other by using the rotating shaft assembly, to implement relative folding or relative unfolding between the primary device part and the secondary device part. When an electrical signal needs to be transmitted between the primary device part and the secondary device part, a flexible circuit board is generally disposed between the primary device part and the secondary device part after passing through the rotating shaft assembly. Specifically, one end of the flexible circuit board is connected to a circuit board on the primary device part, and the other end of the flexible circuit board is connected to a circuit board on the secondary device part. In addition, when the passing through the rotating shaft assembly, the flexible circuit board is further fixedly connected to the rotating shaft assembly.

However, when the foldable electronic device is in a flattened state, because a redundant length of the flexible circuit board is relatively large, the flexible circuit board cannot form a bending form of an arc or an R angle radius of the arc is small. Consequently, the flexible circuit board is prone to be at the risk of excessive folding-induced wire break or bending fatigue-induced wire break.

CN216743503U discloses a folding electronic device that comprises a folding device, a shell and a flexible part. The shell comprises a first shell and a second shell distributed along a width direction of the folding electronic device. The first shell and the second shell are capable of rotating around the folding device to put the folding electronic device in a folded state or in an unfolded state. The flexible part comprises a body portion and a bending section.
US2018324964A1 discloses an electronic device comprising a first housing including a first surface facing a first direction and a second surface facing a second direction opposite the first direction, a second housing including a third surface facing a third direction and a fourth surface facing a fourth direction opposite the third direction, a hinge disposed between the first housing and the second housing, and a flexible display disposed from the first surface of the first housing across the hinge to the third surface of the second housing.
US6831229B1 discloses a hinge cover mechanism for an electric device with a folding casing being constituted by at least a first casing part and a second casing part, which are adjoined by a hinge mechanism. The hinge cover mechanism comprises a hinge cover component comprising at least first pivot means, which cooperate with the second casing part to allow movement of the hinge cover component about first cover pivot axis and second pivot means, which cooperate with the first casing part to allow both linear movement of the hinge cover component and pivotal movement of the hinge cover component about second cover pivot axis.

### SUMMARY

Embodiments of this application provide a foldable electronic device and a shaft cover assembly, so that a problem that a flexible circuit board cannot form a bending form of an arc or an R angle radius of the arc is small because a redundant length of the flexible circuit board is relatively large when the foldable electronic device is in a flattened state can be avoided. Therefore, the flexible circuit board can be prevented from being at the risk of excessive folding-induced wire break or bending fatigue-induced wire break, so that user experience of a flexible display screen body can be prevented from being affected.

A first aspect of the embodiments of this application provides a foldable electronic device, where the foldable electronic device includes at least a first middle frame part, a second middle frame part, and a rotating shaft assembly, where the first middle frame part and the second middle frame part are rotatably connected to each other by using the rotating shaft assembly; the foldable electronic device further includes a flexible circuit board and at least one shaft cover assembly; and the at least one shaft cover assembly is rotatably connected to the rotating shaft assembly; and the flexible circuit board is fixedly connected to the at least one shaft cover assembly, and in a process in which the first middle frame part and the second middle frame part are folded or unfolded relative to each other, the at least one shaft cover assembly moves back and forth relative to the rotating shaft assembly in a thickness direction of the foldable electronic device.

According to the foldable electronic device provided in the embodiments of this application, in the foldable electronic device, the flexible circuit board is fixedly connected to the at least one shaft cover assembly, and the shaft cover assembly may move back and forth relative to the rotating shaft assembly in the thickness direction of the foldable electronic device. In this way, in a folding or unfolding process of the foldable electronic device, that is, in the process in which the first middle frame part and the second middle frame part are folded or unfolded relative to each other, a distance between the at least one shaft cover assembly and the rotating shaft assembly changes. Because the flexible circuit board is fixedly connected to the shaft cover assembly, the flexible circuit board also moves back and forth relative to the rotating shaft assembly in the thickness direction of the foldable electronic device. Therefore, a redundant length of the flexible circuit board can adapt to the distance between the shaft cover assembly and the rotating shaft assembly, so that a problem that the flexible circuit board cannot form a bending form of an arc or an R angle radius of the arc is small because the redundant length of the flexible circuit board is relatively large when the foldable electronic device is in a flattened state can be avoided. Therefore, the flexible circuit board can be prevented from being at the risk of excessive folding-induced wire break or bending fatigue-induced wire break, so that user experience of a flexible display screen body can be prevented from being affected.

In a possible implementation, the foldable electronic device further includes a first circuit board and a second circuit board, where the first circuit board is located on the first middle frame part, the second circuit board is located on the second middle frame part, one end of the flexible circuit board is connected to the first circuit board, and the other end of the flexible circuit board is connected to the second circuit board after passing through the rotating shaft assembly.

In this way, one end of the flexible circuit board is connected to the first circuit board on the first middle frame part, and the other end of the flexible circuit board is connected to the second circuit board on the second middle frame part. When the flexible circuit board that is used to connect to the first circuit board and the second circuit board passes through the rotating shaft assembly, because the flexible circuit board is fixedly connected to the shaft cover assembly, the flexible circuit board also moves back and forth relative to the rotating shaft assembly in the thickness direction of the foldable electronic device.

In a possible implementation, the rotating shaft assembly includes a rotating shaft, a first swing arm, and a second swing arm; and the first swing arm and the second swing arm are separately rotatably connected to the rotating shaft, the first swing arm is fixedly connected to the first middle frame part, and the second swing arm is fixedly connected to the second middle frame part.

The first swing arm and the second swing arm are separately rotatably connected to the rotating shaft, the first swing arm is fixedly connected to the first middle frame part, and the second swing arm is fixedly connected to the second middle frame part. Therefore, it can be ensured that when the first swing arm and the second swing arm rotate relative to each other by using the rotating shaft, the first middle frame part and the second middle frame part are driven to rotate relative to each other, so that relative folding or relative unfolding between the first middle frame part and the second middle frame part can be implemented.

In a possible implementation, each of the at least one shaft cover assembly includes a shaft cover, a first fastener, and two linkage members; two sliding grooves are disposed on the shaft cover, and one end of each linkage member is located in the sliding groove and is slidably connected to the sliding groove; two rotating cavities are disposed on the first fastener, and the other end of each linkage member is located in the rotating cavity and is rotatably connected to the rotating cavity; and the flexible circuit board is fixedly connected to the shaft cover, the first fastener is fixedly connected to the rotating shaft, one of the two linkage members is fixedly connected to the first swing arm, and the other of the two linkage members is fixedly connected to the second swing arm.

Two sliding grooves are disposed on each shaft cover, one end of each of the two linkage members is respectively located in the two sliding grooves and is slidably connected to the sliding groove, two rotating cavities are disposed on each first fastener, and the other end of each of the two linkage members is respectively located in the two rotating cavities and is rotatably connected to the rotating cavity. When the first swing arm and the second swing arm of the rotating shaft assembly separately rotate around the rotating shaft, the first swing arm and the second swing arm drive one end of the linkage member to rotate in the two rotating cavities on the first fastener. At the same time, the other end of the linkage member generates horizontal and vertical displacement in the sliding groove on the shaft cover. Because the first fastener is fixedly connected to the rotating shaft, if a distance between the first fastener and the shaft cover changes, a distance between the rotating shaft and the shaft cover changes. Because the flexible circuit board is fixedly connected to the shaft cover, the flexible circuit board also moves back and forth relative to the rotating shaft in the thickness direction of the foldable electronic device. Therefore, the redundant length of the foldable electronic device can adapt to the distance between the shaft cover and the rotating shaft, so that the flexible circuit board can be prevented from being at the risk of excessive folding-induced wire break or bending fatigue-induced wire break in the folding or unfolding process of the foldable electronic device.

In a possible implementation, the shaft cover includes a shaft cover body and a second fastener fixedly connected to the shaft cover body; and the flexible circuit board is fixedly connected to the shaft cover body, and the sliding groove is located on the second fastener. The shaft cover body of the shaft cover is used to be fixedly connected to the flexible circuit board, and the sliding groove is disposed on the second fastener of the shaft cover, to cooperate with the linkage member.

In a possible implementation, the flexible circuit board is fixedly connected to a side that is of the shaft cover body and that faces away from the rotating shaft assembly.

In this way, in the folding or unfolding process of the foldable electronic device, when a distance between the shaft cover body and the rotating shaft assembly changes, because the flexible circuit board is fixedly connected to the side that is of the shaft cover body and that faces away from the rotating shaft assembly, the flexible circuit board also moves back and forth relative to the rotating shaft assembly in the thickness direction of the foldable electronic device, so that the redundant length of the flexible circuit board can adapt to the distance between the shaft cover body and the rotating shaft of the rotating shaft assembly.

In a possible implementation, the linkage member includes a rotating part and a sliding part connected to the rotating part; the rotating part is located in the rotating cavity and is rotatably connected to the rotating cavity; and the sliding part is located in the sliding groove and is slidably connected to the sliding groove.

In this way, when the first swing arm and the second swing arm of the rotating shaft assembly separately rotate around the rotating shaft, the first swing arm and the second swing arm drive the rotating part of the linkage member to rotate in the two rotating cavities on the first fastener. At the same time, the sliding part of the linkage member generates horizontal and vertical displacement in the sliding groove on the shaft cover.

In a possible implementation, the sliding groove is a D-shaped groove. The sliding groove is designed as a D-shaped groove, to help the linkage member generate horizontal and vertical displacement in the sliding groove.

In a possible implementation, a central axis of the rotating part in an axial direction of the linkage member does not coincide with a central axis of the sliding part in the axial direction of the linkage member.

The central axis of the rotating part of the linkage member in the axial direction of the linkage member is designed not to coincide with the central axis of the sliding part of the linkage member in the axial direction of the linkage member, so that the linkage member can form an eccentric rod structure. In this way, in the folding or unfolding process of the foldable electronic device, the first swing arm and the second swing arm of the rotating shaft assembly rotate around the central axis in the axial direction of the linkage member, and correspondingly drive the linkage member to move. The linkage member is of an eccentric rod structure, and there is a horizontal sliding degree of freedom between the linkage member and the second fastener of the shaft cover. Therefore, when the linkage member rotates, a component in a vertical movement direction drives the second fastener of the shaft cover to rotate, so that the distance between the shaft cover and the rotating shaft is increased in the unfolding process of the foldable electronic device, and the distance between the shaft cover and the rotating shaft is decreased in the folding process of the foldable electronic device.

In a possible implementation, a size of the rotating part in a radial direction of the linkage member is less than a size of the sliding part in the radial direction of the linkage member. Because the size of the rotating part in the radial direction of the linkage member is less than the size of the sliding part in the radial direction of the linkage member, it can be ensured that the central axis of the rotating part of the linkage member in the axial direction of the linkage member is designed not to coincide with the central axis of the sliding part of the linkage member in the axial direction of the linkage member, so that the linkage member can form an eccentric rod structure.

In a possible implementation, in a process in which the first swing arm and the second swing arm are folded relative to each other, the shaft cover assembly moves towards the rotating shaft in the thickness direction of the foldable electronic device; and in a process in which the first swing arm and the second swing arm are unfolded relative to each other, the shaft cover assembly moves away from the rotating shaft in the thickness direction of the foldable electronic device.

In the process in which the first swing arm and the second swing arm are folded relative to each other, the shaft cover assembly moves towards the rotating shaft in the thickness direction of the foldable electronic device, so that the distance between the shaft cover assembly and the rotating shaft of the rotating shaft assembly is gradually decreased. In the process in which the first swing arm and the second swing arm are unfolded relative to each other, the shaft cover assembly moves away from the rotating shaft in the thickness direction of the foldable electronic device, so that the distance between the shaft cover assembly and the rotating shaft of the rotating shaft assembly is gradually increased.

In a possible implementation, when the first swing arm and the second swing arm are unfolded to a same plane relative to each other, a distance between the shaft cover assembly and the rotating shaft is a first preset distance; when the first swing arm and the second swing arm are folded to a same plane relative to each other, the distance between the shaft cover assembly and the rotating shaft is a second preset distance; and a difference between the first preset distance and the second preset distance is 1 mm-1.7 mm.

### BRIEF DESCRIPTION OF DRAWINGS

FIG. 1 is a schematic diagram of a three-dimensional structure of a foldable screen mobile phone in a folded state according to an embodiment of this application;
FIG. 2 is a schematic diagram of a three-dimensional structure of a foldable screen mobile phone in a semi-folded state according to an embodiment of this application;
FIG. 3 is a schematic diagram of a three-dimensional structure of a foldable screen mobile phone in an unfolded state according to an embodiment of this application;
FIG. 4 is a schematic diagram of a cross-sectional structure of a foldable screen mobile phone in a folded state and an unfolded state in the conventional technology;
FIG. 5 is a schematic diagram of a cross-sectional structure of a foldable screen mobile phone in an unfolded state in the conventional technology;
FIG. 6 is a schematic diagram of a cross-sectional structure of a foldable screen mobile phone in a folded state and an unfolded state according to an embodiment of this application;
FIG. 7 is a schematic diagram of a three-dimensional structure of a rotating shaft assembly and a shaft cover assembly in a foldable screen mobile phone in an unfolded state according to an embodiment of this application;
FIG. 8 is a schematic diagram of a three-dimensional structure of a rotating shaft assembly and a shaft cover assembly in a foldable screen mobile phone in a folded state according to an embodiment of this application;
FIG. 9 is an exploded view of FIG. 7;
FIG. 10 is an exploded view of FIG. 8;
FIG. 11 is a schematic diagram of a cross-sectional structure of a rotating shaft assembly and a shaft cover assembly in a foldable screen mobile phone in an unfolded state according to an embodiment of this application;
FIG. 12 is an enlarged schematic view of a position A in FIG. 11;
FIG. 13 is a schematic diagram of a three-dimensional structure of a rotating shaft assembly and a shaft cover assembly in a foldable screen mobile phone in an unfolded state according to an embodiment of this application; and
FIG. 14 is a schematic diagram of a three-dimensional structure of a rotating shaft assembly and a shaft cover assembly in a foldable screen mobile phone in a folded state according to an embodiment of this application.

### Descriptions of reference numerals:

100-foldable screen mobile phone; 110-first middle frame part; 120-second middle frame part;
130-rotating shaft assembly; 131-rotating shaft; 132-first swing arm;
133-second swing arm; 140-display screen body; 150-rear cover;
160-first circuit board; 170-second circuit board; 180-flexible circuit board;
190-shaft cover assembly; 191-shaft cover; 1911-sliding groove;
1912-shaft cover body; 1913-second fastener; 192-first fastener;
1921-rotating cavity; 193-linkage member; 1931-rotating part; and
1932-sliding part.

### DESCRIPTION OF EMBODIMENTS

Terms used in the implementation part of this application are merely intended to explain specific embodiments of this application, and are not intended to limit this application. Implementations of the embodiments of this application are described in detail below with reference to the accompanying drawings.

Emergence of a flexible screen breaks through a display manner of an original display device. A foldable electronic device can multiply information exchange efficiency through one or more times of simple folding. In a future design such a plurality of times of folding and a scroll type, an information exchange manner can be totally changed. A foldable electronic display screen can flexibly change and switch a mode based on different use scenarios, and can also provide a high screen-to-body ratio and clarity, and gradually becomes a hot spot for people to research.

Embodiments of this application provide a foldable electronic device that may include but is not limited to a mobile or fixed terminal having a foldable function, for example, a mobile phone, a tablet computer, a notebook computer, an ultra-mobile personal computer (ultra-mobile personal computer, UMPC), a handheld computer, a touch television, a walkie-talkie, a netbook, a point of sales (Point of sales, POS) terminal, a personal digital assistant (personal digital assistant, PDA), a wearable device, a virtual reality device, a wireless USB flash, a Bluetooth speaker/headset/glasses, an in-vehicle original equipment, an event data recorder, or a security protection device.

In the embodiments of this application, an example in which a foldable screen mobile phone is the foregoing foldable electronic device is used for description. The foldable screen mobile phone provided in the embodiments of this application may be a curved screen mobile phone or a flat screen mobile phone. In the embodiments of this application, the flat screen mobile phone is used as an example for description.

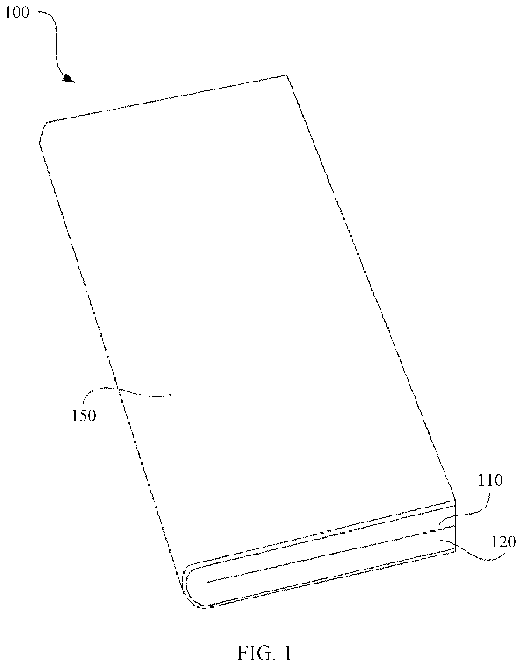

Referring to FIG. 1 to FIG. 3, an example in which the foldable electronic device is a foldable screen mobile phone 100 is used. The foldable screen mobile phone 100 may include a first middle frame part 110 and a second middle frame part 120. There is a bending region between the first middle frame part 110 and the second middle frame part 120. For example, a rotating shaft assembly 130 may be disposed in the bending region, and the rotating shaft assembly 130 is located between the first middle frame part 110 and the second middle frame part 120. In addition, the first middle frame part 110 and the second middle frame part 120 may be rotatably connected to each other by using the rotating shaft assembly 130, to implement relative folding and relative unfolding between the first middle frame part 110 and the second middle frame part 120.

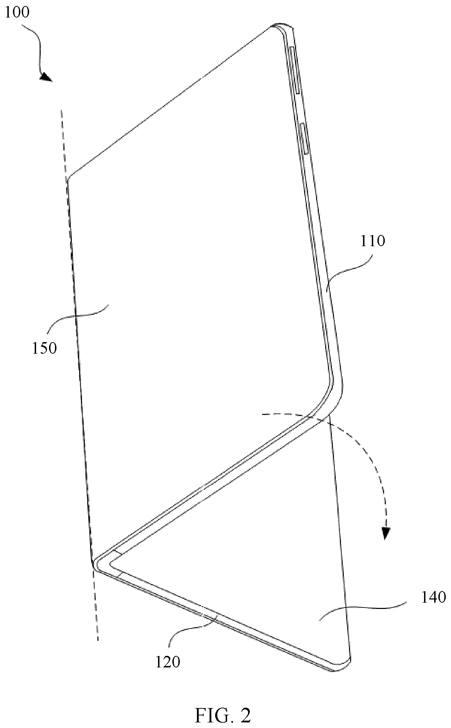

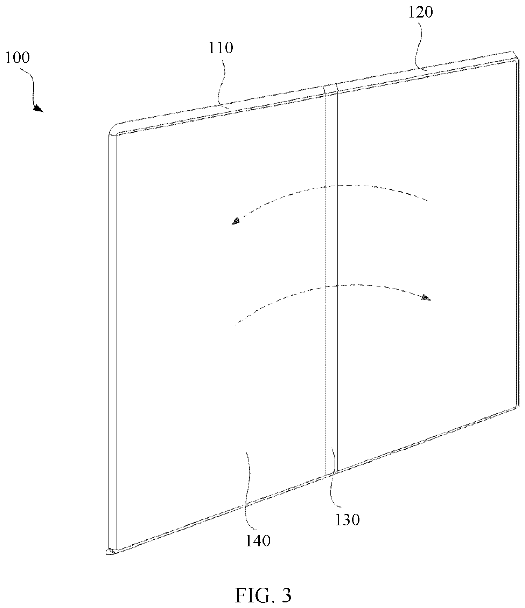

In this embodiment of this application, as shown in FIG. 2 or FIG. 3, the foldable screen mobile phone 100 may further include a display screen body 140. The display screen body 140 may be a flexible display screen body 140, and the flexible display screen body 140 may cover one side of each of the first middle frame part 110, the rotating shaft assembly 130, and the second middle frame part 120. In this way, the flexible display screen body 140 may correspondingly present a state such as folded or unfolded with rotation of the first middle frame part 110 and the second middle frame part 120.

For example, when the first middle frame part 110 and the second middle frame part 120 rotate in a direction close to each other to a folded state (referring to FIG. 1), the flexible display body 140 of the foldable screen mobile phone 100 is also in a folded state and is between the first middle frame part 110 and the second middle frame part 120. When the first middle frame part 110 and the second middle frame part 120 rotate in a direction away from each other to an unfolded state (referring to FIG. 3), until the first middle frame part 110 and the second middle frame part 120 are located on a same horizontal plane, the flexible display screen body 140 of the foldable screen mobile phone 100 is also in an unfolded state.

In this embodiment of this application, because the display screen body 140 needs to be folded, the display screen body 140 may be a flexible display screen body, for example, the flexible display screen body may be an organic light-emitting diode (Organic Light-Emitting Diode, OLED) display screen.

It should be noted that the foldable screen mobile phone 100 may have two or more middle frame parts (referring to FIG. 1 to FIG. 3), and when there are two or more middle frame parts, adjacent middle frame parts may rotate around a mutually parallel rotating shaft assembly 130, to form a plurality of layers of middle frame parts, or obtain a larger display area after unfolding. In this embodiment of this application, an example in which the foldable screen mobile phone 100 has two middle frame parts (namely, the first middle frame part 110 and the second middle frame part 120) is mainly used for description.

Further, the foldable screen mobile phone 100 may further include a rear cover 150. As shown in FIG. 1 or FIG. 2, the rear cover 150 is located on one side that is of each of the first middle frame part 110, the rotating shaft assembly 130, and the second middle frame part 120 and that faces away from the display screen body 140. For example, the first middle frame part 110, the rotating shaft assembly 130, and the second middle frame part 120 all are located between the display screen body 140 and the rear cover 150.

It may be understood that the structure shown in this embodiment of this application does not constitute a specific limitation on the electronic device. In some other embodiments of the embodiments of this application, the foldable screen mobile phone 100 may include more or fewer components than those shown in the figure, or combine some components, or split some components, or have different component arrangements. For example, the foldable screen mobile phone 100 may further include components such as a camera module and a flash light. The components shown in the figure may be implemented by using hardware, software, or a combination of software and hardware.

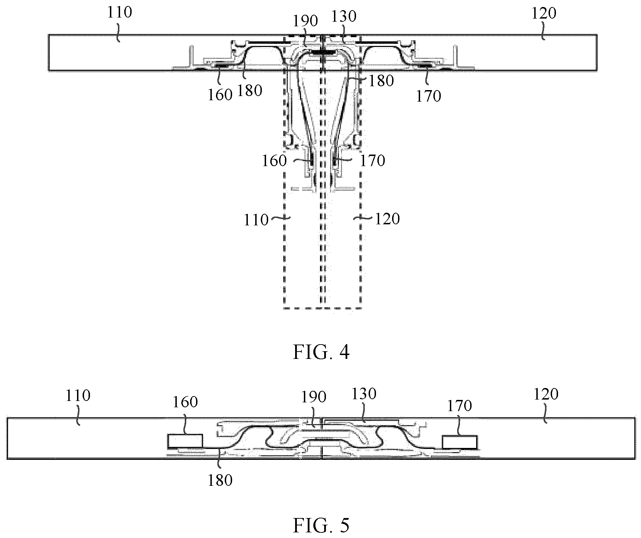

In a related technology, as shown in FIG. 4 and FIG. 5, the foldable electronic device generally includes the first middle frame part 110, the second middle frame part 120, and the rotating shaft assembly 130. The first middle frame part 110 and the second middle frame part 120 are rotatably connected to each other by using the rotating shaft assembly 130, to implement relative folding or relative unfolding between the first middle frame part 110 and the second middle frame part 120. When an electrical signal needs to be transmitted between a first circuit board 160 located on the first middle frame part 110 and a second circuit board 170 located on the second middle frame part 120, a flexible circuit board 180 is generally disposed between the first circuit board 160 and the second circuit board 170 after passing through the rotating shaft assembly 130. Specifically, referring to FIG. 4 and FIG. 5, one end of the flexible circuit board 180 is connected to the first circuit board 160, and the other end of the flexible circuit board 180 is connected to the second circuit board 170. In addition, when passing through the rotating shaft assembly 130, the flexible circuit board 180 is further fixedly connected to the rotating shaft assembly 130, to implement fixing at positions of three fixing points of the flexible circuit board 180.

Currently, to improve reliability of the display screen body 140, the display screen body 140 is generally designed as a water drop-like structure in a folded state, to form larger space to accommodate the bent display panel body 140. However, due to the design of the water drop-like structure, the rotating shaft assembly 130 is very complex, causing a very long lateral length of the rotating shaft assembly 130. Consequently, the flexible circuit board 180 that passes through the rotating shaft assembly 130 needs to implement an electrical connection between the first circuit board 160 and the second circuit board 170 at a long distance.

In a process in which the foldable electronic device is switched between an unfolded state and a folded state, relative movement between the rotating shaft assembly 130 and each of the first middle frame part 110 and the second middle frame part 120 occurs. Therefore, the flexible circuit board 180 that passes through the rotating shaft assembly 130 is prone to have different forms in an unfolded state and a folded state.

For example, when the foldable electronic device is in a folded state, a fixing point at which the flexible circuit board 180 is connected to the first circuit board 160 and a fixing point at which the flexible circuit board 180 is connected to the second circuit board 170 are far apart from each other, resulting in a relatively long path of the entire flexible circuit board 180. In this case, a form of the flexible circuit board 180 is a taut and straight state (referring to FIG. 4). When the foldable electronic device is in an unfolded state, a fixing point at which the flexible circuit board 180 is connected to the first circuit board 160 and a fixing point at which the flexible circuit board 180 is connected to the second circuit board 170 are relatively close to each other. In other words, a straight-line connection distance between the two fixing points of the flexible circuit board 180 in an unfolded state is shorter than a distance between the two fixing points of the flexible circuit board 180 in a folded state. In addition, fastening is performed at all the fixing points of the flexible circuit board 180 by using a screw for pressing, and no relative movement occurs in a bending process. Therefore, in a process of moving from a folded state to an unfolded state, the flexible circuit board 180 generates length redundancy, and generally needs to be accommodated in the entire device in a bending form of a good arc.

However, with continuous thinning of the entire device design, when the foldable electronic device is in a flattened state, because the redundant length of the flexible circuit board 180 is relatively large and cannot be absorbed, the flexible circuit board 180 cannot form a bending form of an arc or an R angle radius of the arc is small. Consequently, the flexible circuit board 180 is prone to be at an undesirable risk of excessive folding-induced wire break or bending fatigue-induced wire break.

Based on this, an embodiment of this application provides a new foldable electronic device. The foldable electronic device may be, for example, the foldable screen mobile phone 100 or a foldable screen computer (that the foldable electronic device is the foldable screen mobile phone 100 is used as an example below), to resolve the foregoing technical problem.

With reference to specific accompanying drawings, a specific structure of the foldable screen mobile phone 100 is described in detail below.

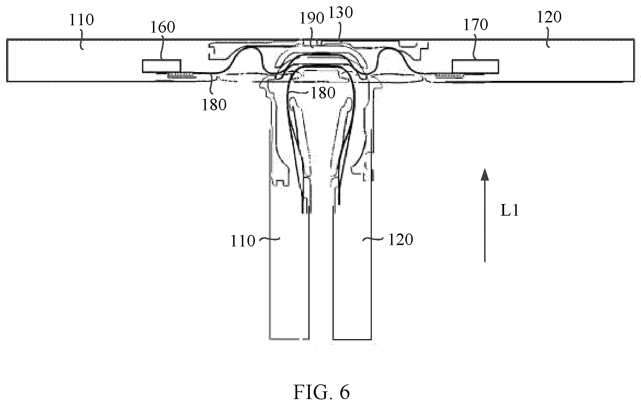

Referring to FIG. 6, an embodiment of this application provides a foldable screen mobile phone 100. Specifically, the foldable screen mobile phone 100 may include at least a first middle frame part 110, a second middle frame part 120, and a rotating shaft assembly 130. The first middle frame part 110 and the second middle frame part 120 may be rotatably connected to each other by using the rotating shaft assembly 130.

In this embodiment of this application, the foldable screen mobile phone 100 may further include a first circuit board 160, a second circuit board 170, and a flexible circuit board 180. The first circuit board 160 is located on the first middle frame part 110, the second circuit board 170 is located on the second middle frame part 120, one end of the flexible circuit board 180 is connected to the first circuit board 160, and the other end of the flexible circuit board 180 is connected to the second circuit board 170 after passing through the rotating shaft assembly 130.

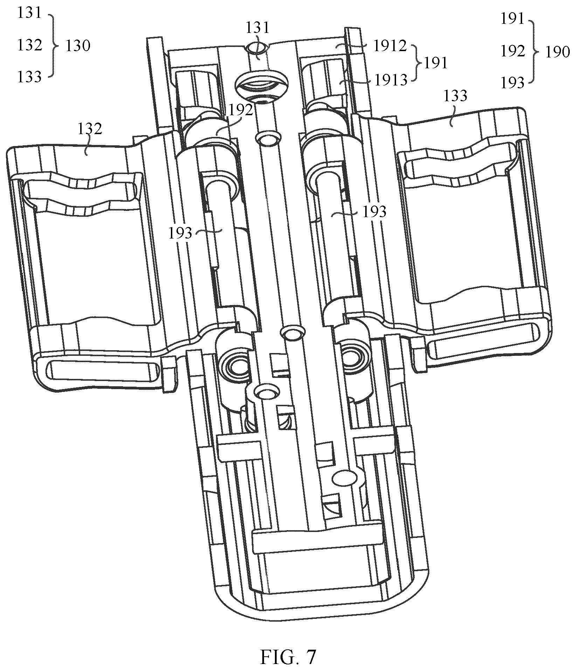

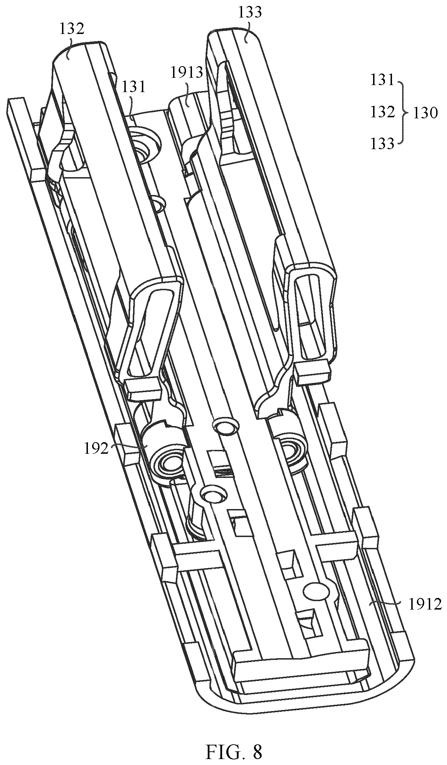

FIG. 7 is a schematic diagram of a three-dimensional structure of a rotating shaft assembly and a shaft cover assembly in a foldable screen mobile phone in an unfolded state according to an embodiment of this application. FIG. 8 is a schematic diagram of a three-dimensional structure of a rotating shaft assembly and a shaft cover assembly in a foldable screen mobile phone in a folded state according to an embodiment of this application.

Referring to FIG. 7 and FIG. 8, the foldable screen mobile phone 100 may further include at least one shaft cover assembly 190. The flexible circuit board 180 is fixedly connected to the shaft cover assembly 190. In a process in which the first middle frame part 110 and the second middle frame part 120 are folded or unfolded relative to each other, the shaft cover assembly 190 may move back and forth relative to the rotating shaft assembly 130 in a thickness direction of the foldable screen mobile phone 100.

In the foldable screen mobile phone 100, still referring to FIG. 6, one end of the flexible circuit board 180 may be connected to the first circuit board 160 on the first middle frame part 110, and the other end of the flexible circuit board 180 is connected to the second circuit board 170 on the second middle frame part 120. In addition, when the flexible circuit board 180 that is used to connect to the first circuit board 160 and the second circuit board 170 passes through the rotating shaft assembly 130, because the flexible circuit board 180 is further fixedly connected to the shaft cover assembly 190, the shaft cover assembly 190 may move back and forth relative to the rotating shaft assembly 130 in the thickness direction of the foldable screen mobile phone 100.

It should be noted that, in this embodiment of this application, the thickness direction of the foldable screen mobile phone 100 is a direction pointed to by L1 in FIG. 6 when the foldable screen mobile phone 100 is in a flattened state.

In a folding or unfolding process of the foldable screen mobile phone 100, that is, in the process in which the first middle frame part 110 and the second middle frame part 120 are folded or unfolded relative to each other, a distance between the shaft cover assembly 190 and the rotating shaft assembly 130 changes, that is, a floating fastening design is formed between the shaft cover assembly 190 and the rotating shaft assembly 130.

In addition, because the flexible circuit board 180 is fixedly connected to the shaft cover assembly 190, the flexible circuit board 180 also moves back and forth relative to the rotating shaft assembly 130 in the thickness direction of the foldable screen mobile phone 100, so that the flexible circuit board 180 is floatingly fastened relative to the shaft cover assembly 190, and moves together with the shaft cover assembly 190. Therefore, the redundant length of the flexible circuit board 180 can adapt to the distance between the shaft cover assembly 190 and the rotating shaft assembly 130.

Specifically, when the foldable screen mobile phone 100 moves from a folded state to an unfolded state, the shaft cover assembly 190 moves in a direction facing away from the rotating shaft assembly 130. Because the flexible circuit board 180 is fastened to the shaft cover assembly 190, the flexible circuit board 180 moves together with the shaft cover assembly 190 in the direction facing away from the rotating shaft assembly 130.

Compared with a scenario in the conventional technology in which the distance between the shaft cover assembly 190 and the rotating shaft assembly 130 remains unchanged, in this embodiment of this application, the distance between the shaft cover assembly 190 and the rotating shaft assembly 130 is increased, so that accommodation space formed between the shaft cover assembly 190 and the rotating shaft assembly 130 is also increased, a longer flexible circuit board 180 is accommodated in a Z direction, and distribution of the redundant length of the flexible circuit board 180 is optimized. Therefore, a length of the flexible circuit board 180 covering the shaft cover assembly 190 is relatively shortened, so that smoother transition of a larger R angle radius can be formed. This greatly improves a bending life and reliability of the flexible circuit board 180, and avoids excessive folding-induced wire break.

In conclusion, in this embodiment of this application, a problem that the flexible circuit board 180 cannot form a bending form of an arc or an R angle radius of the arc is small because the redundant length of the flexible circuit board 180 is relatively large when the foldable electronic device is in a flattened state can be avoided. Therefore, the flexible circuit board 180 can be prevented from being at the risk of excessive folding-induced wire break or bending fatigue-induced wire break, so that user experience of a flexible display screen body can be prevented from being affected.

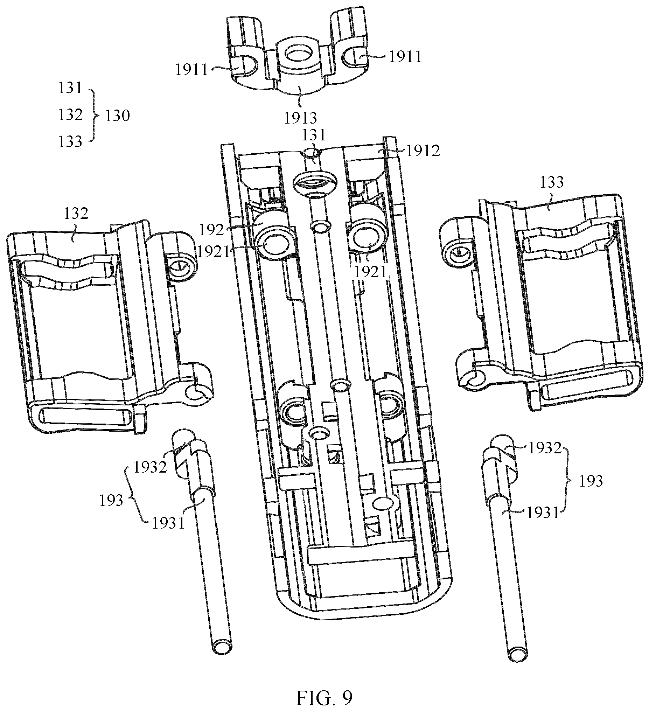

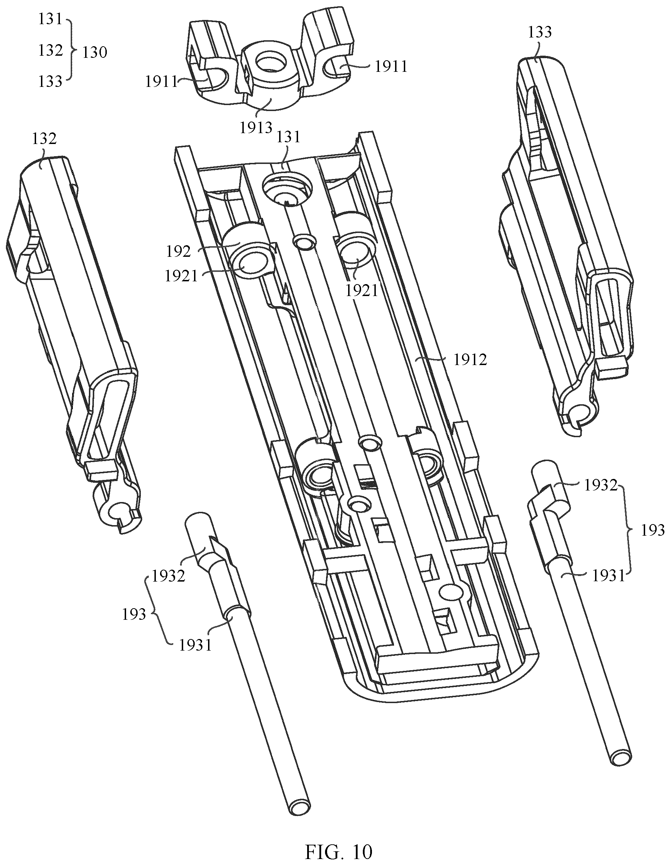

It may be understood that, in this embodiment of this application, referring to FIG. 9 and FIG. 10, the rotating shaft assembly 130 may include a rotating shaft 131, a first swing arm 132, and a second swing arm 133. The first swing arm 132 and the second swing arm 133 are separately rotatably connected to the rotating shaft 131. In addition, the first swing arm 132 is fixedly connected to the first middle frame part 110, and the second swing arm 133 is fixedly connected to the second middle frame part 120.

The first swing arm 132 and the second swing arm 133 are separately rotatably connected to the rotating shaft 131. In addition, the first swing arm 132 is fixedly connected to the first middle frame part 110, and the second swing arm 133 is fixedly connected to the second middle frame part 120. Therefore, it can be ensured that when the first swing arm 132 and the second swing arm 133 rotate relative to each other by using the rotating shaft 131, the first middle frame part 110 and the second middle frame part 120 are driven to rotate relative to each other, so that relative folding or relative unfolding between the first middle frame part 110 and the second middle frame part 120 can be implemented.

In addition, in this embodiment of this application, still referring to FIG. 7, each shaft cover assembly 190 may include a shaft cover 191, a first fastener 192, and two linkage members 193. Two sliding grooves 1911 are disposed on the shaft cover 191, and one end of each linkage member 193 is located in the sliding groove 1911 and is slidably connected to the sliding groove 1911. Two rotating cavities 1921 are disposed on the first fastener 192, and the other end of each linkage member 193 is located in the rotating cavity 1921 and is rotatably connected to the rotating cavity 1921.

In addition, the first fastener 192 is fixedly connected to the rotating shaft 131, one of the two linkage members 193 is fixedly connected to the first swing arm 132, and the other of the two linkage members 193 is fixedly connected to the second swing arm 133.

In a possible implementation, the flexible circuit board 180 may be fixedly connected to the shaft cover 191 of the shaft cover assembly 190.

Two sliding grooves 1911 are disposed on each shaft cover 191, one end of each of the two linkage members 193 is respectively located in the two sliding grooves 1911 and is slidably connected to the sliding groove 1911, two rotating cavities 1921 are disposed on each first fastener 192, and the other end of each of the two linkage members 193 is respectively located in the two rotating cavities 1921 and is rotatably connected to the rotating cavity 1921. When the first swing arm 132 and the second swing arm 133 of the rotating shaft assembly 130 separately rotate around the rotating shaft 131, the first swing arm 132 and the second swing arm 133 drive one end of the linkage member 193 to rotate in the two rotating cavities 1921 on the first fastener 192. At the same time, the other end of the linkage member 193 generates horizontal and vertical displacement in the sliding groove 1911 on the shaft cover 191.

Because the first fastener 192 is fixedly connected to the rotating shaft 131, if a distance between the first fastener 192 and the shaft cover 191 changes, a distance between the rotating shaft 131 and the shaft cover 191 changes. Because the flexible circuit board 180 is fixedly connected to the shaft cover 191, the flexible circuit board 180 also moves back and forth relative to the rotating shaft 131 in the thickness direction of the foldable screen mobile phone 100. Therefore, the redundant length of the foldable electronic device 180 can adapt to the distance between the shaft cover 191 and the rotating shaft 131, so that the flexible circuit board 180 can be prevented from being at the risk of excessive folding-induced wire break or bending fatigue-induced wire break in the folding or unfolding process of the foldable screen mobile phone 100.

It should be noted that, in this embodiment of this application, as shown in FIG. 7 and FIG. 8, the shaft cover 191 may include a shaft cover body 1912 and a second fastener 1913 fixedly connected to the shaft cover body 1912. The sliding groove 1911 may be located on the second fastener 1913.

In addition, in a possible implementation, the flexible circuit board 180 may be fixedly connected to the shaft cover body 1912 (not shown in the figure).

In other words, the shaft cover body 1912 of the shaft cover 191 is used to be fixedly connected to the flexible circuit board 180, the sliding groove 1911 is disposed on the second fastener 1913 of the shaft cover 191, and the sliding groove 1911 is used to cooperate with the linkage member 193.

In addition, in some embodiments, the flexible circuit board 180 may be fixedly connected to a side that is of the shaft cover body 1912 and that faces away from the rotating shaft assembly 130.

In this way, in the folding or unfolding process of the foldable screen mobile phone 100, referring to FIG. 6, when a distance between the shaft cover assembly 190 and the rotating shaft assembly 130 changes, because the flexible circuit board 180 is fixedly connected to the side that is of the shaft cover assembly 190 and that faces away from the rotating shaft assembly 130, the flexible circuit board 180 also moves back and forth relative to the rotating shaft assembly 130 in the thickness direction of the foldable screen mobile phone 100, so that the redundant length of the flexible circuit board 180 can adapt to the distance between the shaft cover assembly 190 and the rotating shaft assembly 130.

In this embodiment of this application, referring to FIG. 9 or FIG. 10, the sliding groove 1911 may be a D-shaped groove. The sliding groove 1911 is designed as a D-shaped groove, to help the linkage member 193 generate horizontal and vertical displacement in the sliding groove 1911.

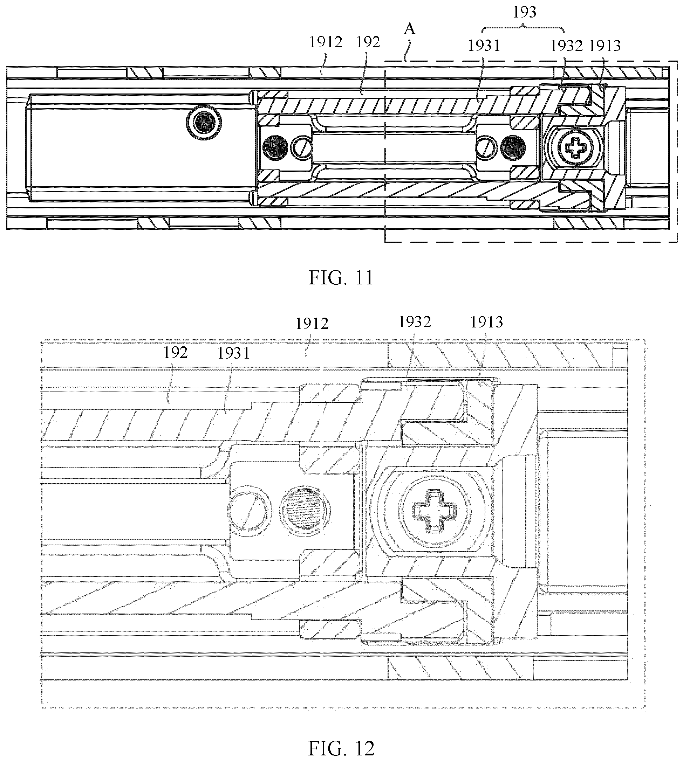

As shown in FIG. 11 or FIG. 12, it may be understood that, in this embodiment of this application, the linkage member 193 may include a rotating part 1931 and a sliding part 1932 connected to the rotating part 1931. The rotating part 1931 may be located in the rotating cavity 1921, and the rotating part 1931 is rotatably connected to the rotating cavity 1921. The sliding part 1932 may be located in the sliding groove 1911, and the sliding part 1932 is slidably connected to the sliding groove 1911.

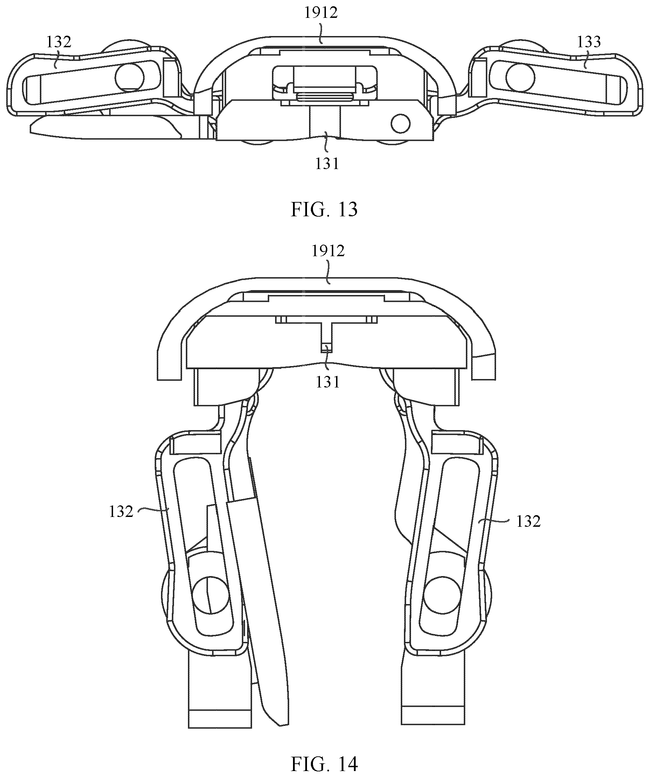

In this way, when the first swing arm 132 and the second swing arm 133 of the rotating shaft assembly 130 separately rotate around the rotating shaft 131 (referring to FIG. 13 and FIG. 14), the first swing arm 132 and the second swing arm 133 drive the rotating part 1931 of the linkage member 193 to rotate in the two rotating cavities 1921 on the first fastener 192. At the same time, the sliding part 1932 of the linkage member 193 generates horizontal and vertical displacement in the sliding groove 1911 on the shaft cover 191.

In addition, it should be noted that, in this embodiment of this application, a central axis of the rotating part 1931 in an axial direction of the linkage member 193 may not coincide with a central axis of the sliding part 1932 in the axial direction of the linkage member 193.

The central axis of the rotating part 1931 of the linkage member 193 in the axial direction of the linkage member 193 is designed not to coincide with the central axis of the sliding part 1932 of the linkage member 193 in the axial direction of the linkage member 193, so that the linkage member 193 can form an eccentric rod structure.

In this way, in the folding or unfolding process of the foldable screen mobile phone 100, the first swing arm 132 and the second swing arm 133 of the rotating shaft assembly 130 rotate around the central axis in the axial direction of the linkage member 193, and correspondingly drive the linkage member 193 to move. The linkage member 193 is of an eccentric structure, and there is a horizontal sliding degree of freedom between the linkage member 193 and the second fastener 1913 of the shaft cover 191.

Therefore, when the linkage member 193 rotates, a component in a vertical movement direction drives the second fastener 1913 of the shaft cover 191 to rotate, so that the distance between the shaft cover 191 and the rotating shaft 131 is increased in the unfolding process of the foldable screen mobile phone 100, and the distance between the shaft cover 191 and the rotating shaft 131 is decreased in the folding process of the foldable screen mobile phone 100.

In a possible implementation, a size of the rotating part 1931 in a radial direction of the linkage member 193 may be less than a size of the sliding part 1932 in the radial direction of the linkage member 193.

Because the size of the rotating part 1931 in the radial direction of the linkage member 193 is less than the size of the sliding part 1932 in the radial direction of the linkage member 193, it can be ensured that the central axis of the rotating part 1931 of the linkage member 193 in the axial direction of the linkage member 193 is designed not to coincide with the central axis of the sliding part 1932 of the linkage member 193 in the axial direction of the linkage member 193, so that the linkage member 193 can form an eccentric rod structure.

It may be understood that, in this embodiment of this application, in a process in which the first swing arm 132 and the second swing arm 133 are folded relative to each other, the shaft cover assembly 190 moves towards the rotating shaft 131 in the thickness direction of the foldable screen mobile phone 100; and in a process in which the first swing arm 132 and the second swing arm 133 are unfolded relative to each other, the shaft cover assembly 190 moves away from the rotating shaft 131 in the thickness direction of the foldable screen mobile phone 100.

Specifically, in the process in which the first swing arm 132 and the second swing arm 133 are folded relative to each other, the shaft cover assembly 190 moves towards the rotating shaft 131 in the thickness direction of the foldable screen mobile phone 100, so that the distance between the shaft cover assembly 190 and the rotating shaft 131 of the rotating shaft assembly 130 is gradually decreased. In the process in which the first swing arm 132 and the second swing arm 133 are unfolded relative to each other, the shaft cover assembly 190 moves away from the rotating shaft 131 in the thickness direction of the foldable screen mobile phone 100, so that the distance between the shaft cover assembly 190 and the rotating shaft 131 of the rotating shaft assembly 130 is gradually increased.

Through back and forth movement of the flexible circuit board 180 in the Z direction of the foldable screen mobile phone 100, an absorption amount of the redundant length of the flexible circuit board 180 can be improved, so that a bending form of the flexible circuit board 180 in a flattened state of the foldable screen mobile phone 100 can be improved, and a service life of the flexible circuit board 180 can be improved.

It may be understood that, in some embodiments, when the first swing arm 132 and the second swing arm 133 are unfolded to a same plane relative to each other, a distance between the shaft cover assembly 190 and the rotating shaft 131 is an initial distance; when the first swing arm 132 and the second swing arm 133 are folded to a same plane relative to each other, the distance between the shaft cover assembly 190 and the rotating shaft 131 is a first preset distance, and a difference between the first preset distance and the initial distance may be 1.0 mm-1.7 mm.

For example, in this embodiment of this application, the difference between the first preset distance and the initial distance may be 1.0 mm, 1.1 mm, 1.2 mm, 1.3 mm, 1.4 mm, 1.5 mm, 1.6 mm, 1.7 mm, or the like. This is not limited in this embodiment of this application.

Specifically, in some application scenarios, the difference between the first preset distance and the initial distance may be 1.19 mm. For example, when the first swing arm 132 and the second swing arm 133 are unfolded to a same plane relative to each other, a distance between the shaft cover assembly 190 and the rotating shaft 131 is an initial distance; when the first swing arm 132 and the second swing arm 133 are folded to 30° relative to each other, the distance between the shaft cover assembly 190 and the rotating shaft 131 is a second preset distance; and a difference between the initial distance and the second preset distance is 0.44 mm.

When the first swing arm 132 and the second swing arm 133 are folded to 60° relative to each other, the distance between the shaft cover assembly 190 and the rotating shaft 131 is a third preset distance, and a difference between the initial distance and the third preset distance is 0.85 mm. When the first swing arm 132 and the second swing arm 133 are folded to a same plane relative to each other, the distance between the shaft cover assembly 190 and the rotating shaft 131 is a first preset distance, and a difference between the initial distance and the first preset distance is 1.19 mm.

In addition, it should be noted that a flexible circuit board that is dynamically bent exists in a terminal device with a dynamic scenario in which the entire device is folded, for example, the foldable screen mobile phone 100 or a notebook computer. In other words, in a terminal device with a dynamic relative movement scenario of the entire device, an electrical connection between structural members with a distance change can be implemented by using different flexible circuit boards in different entire-device working conditions. Therefore, in a thinning and lightening process of the entire device, for the problem that accommodation space of redundancy of the flexible circuit board is insufficient, the solution provided in this embodiment of this application may be used to absorb the redundant length of the flexible circuit board, to optimize and improve a bending form of the flexible circuit board.

In addition, referring to FIG. 7, an embodiment of this application may further provide a shaft cover assembly 190 applied to the foldable screen mobile phone 100 in the foregoing embodiment. Specifically, the shaft cover assembly 190 may include a shaft cover 191, a first fastener 192, and two linkage members 193. Two sliding grooves 1911 may be disposed on the shaft cover 191, and one end of each linkage member 193 may be located in the sliding groove 1911 and is slidably connected to the sliding groove 1911. Two rotating cavities 1921 may be disposed on the first fastener 192, and the other end of each linkage member 193 is located in the rotating cavity 1921 and is rotatably connected to the rotating cavity 1921.

The flexible circuit board 180 is fixedly connected to the shaft cover 191, the first fastener 192 is fixedly connected to a rotating shaft 131 of the rotating shaft assembly 130, one of the two linkage members 193 is fixedly connected to a first swing arm 132 of the rotating shaft assembly 130, and the other of the two linkage members 193 is fixedly connected to a second swing arm 133 of the rotating shaft assembly 130.

In some embodiments, as shown in FIG. 7 and FIG. 8, the shaft cover 191 may include a shaft cover body 1912 and a second fastener 1913 fixedly connected to the shaft cover body 1912. The flexible circuit board 180 is fixedly connected to the shaft cover body 1912, and the sliding groove 1911 is located on the second fastener 1913.

In a possible implementation, the flexible circuit board 180 may be fixedly connected to a side that is of the shaft cover body 1912 and that faces away from the rotating shaft assembly 130.

Referring to FIG. 11 or FIG. 12, in this embodiment of this application, the linkage member 193 may include a rotating part 1931 and a sliding part 1932 connected to the rotating part 1931. The rotating part 1931 is located in the rotating cavity 1921 and is rotatably connected to the rotating cavity 1921. The sliding part 1932 is located in the sliding groove 1911 and is slidably connected to the sliding groove 1911.

In the descriptions of the embodiments of this application, it should be noted that unless otherwise specified or limited, terms "mount", "connect", and "connection" shall be understood in a broad sense, for example, may be a fixed connection, may be an indirect connection by using an intermediate medium, or may be a connection between insides of two elements or an interaction relationship between two elements. Persons of ordinary skill in the art may understand specific meanings of the foregoing terms in the embodiments of this application based on a specific situation.

The apparatus or element referred to or implied in the embodiments of this application needs to have a specific orientation, be constructed and operated in a specific orientation, and therefore cannot be construed as a limitation on the embodiments of this specification. In the descriptions of the embodiments of this application, "a plurality of" means two or more, unless otherwise specifically specified.

The terms "first", "second", "third", "fourth", and the like (if existent) in the specification, claims, and accompanying drawings of the embodiments of this application are used to distinguish between similar objects, but are not necessarily used to describe a particular order or sequence. It should be understood that data used in such a way is interchangeable in proper situations, so that the embodiments of this application described herein can be implemented, for example, in orders other than those illustrated or described herein. In addition, the terms "may include", "have", and any other variants thereof are intended to cover a non-exclusive inclusion. For example, a process, method, system, product, or device that includes a list of steps or units is not necessarily limited to those steps or units that are expressly listed, but may include other steps or units that are not expressly listed or are inherent to the process, method, product, or device.

Finally, it should be noted that the foregoing embodiments are merely used to describe the technical solutions of the embodiments of this application, but are not intended to limit the technical solutions of the embodiments of this application. Although the embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of various embodiments of the embodiments of this application.

## Claims

1. A foldable electronic device (100), comprising at least the following:
a first middle frame part (110), a second middle frame part (120), and a rotating shaft assembly (130), wherein
the first middle frame part and the second middle frame part are rotatably connected to each other by using the rotating shaft assembly;
the foldable electronic device further comprises a flexible circuit board (180) and at least one shaft cover assembly (190), and the at least one shaft cover assembly is rotatably connected to the rotating shaft assembly; and
the flexible circuit board is fixedly connected to the at least one shaft cover assembly,
**characterised in that**
in a process in which the first middle frame part and the second middle frame part are folded or unfolded relative to each other, the at least one shaft cover assembly moves back and forth relative to the rotating shaft assembly in a thickness direction of the foldable electronic device.

2. The foldable electronic device according to claim 1, further comprising a first circuit board (160) and a second circuit board (170), wherein
the first circuit board is located on the first middle frame part, the second circuit board is located on the second middle frame part, one end of the flexible circuit board is connected to the first circuit board, and the other end of the flexible circuit board is connected to the second circuit board after passing through the rotating shaft assembly.

3. The foldable electronic device according to claim 1 or 2, wherein the rotating shaft assembly comprises a rotating shaft (131), a first swing arm (132), and a second swing arm (133); and
the first swing arm and the second swing arm are separately rotatably connected to the rotating shaft, the first swing arm is fixedly connected to the first middle frame part, and the second swing arm is fixedly connected to the second middle frame part.

4. The foldable electronic device according to claim 3, wherein each of the at least one shaft cover assembly comprises a shaft cover (191), a first fastener (192), and two linkage members (193);
two sliding grooves (1911) are disposed on the shaft cover, and one end of each linkage member is located in the sliding groove and is slidably connected to the sliding groove;
two rotating cavities are disposed on the first fastener, and the other end of each linkage member is located in the rotating cavity and is rotatably connected to the rotating cavity; and
the flexible circuit board is fixedly connected to the shaft cover, the first fastener is fixedly connected to the rotating shaft, one of the two linkage members is fixedly connected to the first swing arm, and the other of the two linkage members is fixedly connected to the second swing arm.

5. The foldable electronic device according to claim 4, wherein the shaft cover comprises a shaft cover body (1912) and a second fastener fixedly (1913) connected to the shaft cover body; and
the flexible circuit board is fixedly connected to the shaft cover body, and the sliding groove is located on the second fastener.

6. The foldable electronic device according to claim 5, wherein the flexible circuit board is fixedly connected to a side that is of the shaft cover body and that faces away from the rotating shaft assembly.

7. The foldable electronic device according to any one of claims 4-6, wherein the linkage member comprises a rotating part (1931) and a sliding part (1932) connected to the rotating part;
the rotating part is located in the rotating cavity and is rotatably connected to the rotating cavity; and
the sliding part is located in the sliding groove and is slidably connected to the sliding groove.

8. The foldable electronic device according to any one of claims 4-7, wherein the sliding groove is a D-shaped groove.

9. The foldable electronic device according to any one of claims 4-8, wherein a central axis of the rotating part in an axial direction of the linkage member does not coincide with a central axis of the sliding part in the axial direction of the linkage member.

10. The foldable electronic device according to claim 9, wherein a size of the rotating part in a radial direction of the linkage member is less than a size of the sliding part in the radial direction of the linkage member.

11. The foldable electronic device according to any one of claims 4-10, wherein in a process in which the first swing arm and the second swing arm are folded relative to each other, the shaft cover assembly moves towards the rotating shaft in the thickness direction of the foldable electronic device; and
in a process in which the first swing arm and the second swing arm are unfolded relative to each other, the shaft cover assembly moves away from the rotating shaft in the thickness direction of the foldable electronic device.

12. The foldable electronic device according to claim 11, wherein when the first swing arm and the second swing arm are unfolded to a same plane relative to each other, a distance between the shaft cover assembly and the rotating shaft is a first preset distance;
when the first swing arm and the second swing arm are folded to a same plane relative to each other, the distance between the shaft cover assembly and the rotating shaft is a second preset distance; and
a difference between the first preset distance and the second preset distance is 1 mm-1.7 mm.

## Patentansprüche

1. Eine faltbare elektronische Vorrichtung (100), umfassend zumindest Folgendes:
einen ersten Mittelrahmenteil (110), einen zweiten Mittelrahmenteil (120) und eine Drehwellenbaugruppe (130), wobei
der erste Mittelrahmenteil und der zweite Mittelrahmenteil mittels der Drehwellenbaugruppe drehbar miteinander verbunden sind;
die faltbare elektronische Vorrichtung ferner eine flexible Leiterplatte (180) und mindestens eine Wellenabdeckbaugruppe (190) umfasst, wobei die mindestens eine Wellenabdeckbaugruppe drehbar mit der Drehwellenbaugruppe verbunden ist; und
die flexible Leiterplatte ist fest mit der mindestens einen Wellenabdeckbaugruppe verbunden, **dadurch gekennzeichnet, dass** sich während des Faltens oder Entfaltens des ersten Mittelrahmenteils und des zweiten Mittelrahmenteils relativ zueinander die mindestens eine Wellenabdeckbaugruppe in einer Dickenrichtung der faltbaren elektronischen Vorrichtung vorwärts und rückwärts relativ zur Drehwellenbaugruppe bewegt.

2. Die faltbare elektronische Vorrichtung nach Anspruch 1, weiterhin umfassend eine erste Leiterplatte (160) und eine zweite Leiterplatte (170), wobei
die erste Leiterplatte befindet sich auf dem ersten Mittelrahmenteil, die zweite Leiterplatte befindet sich auf dem zweiten Mittelrahmenteil, ein Ende der flexiblen Leiterplatte ist mit der ersten Leiterplatte verbunden, und das andere Ende der flexiblen Leiterplatte ist nach Durchführung durch die Drehwellenbaugruppe mit der zweiten Leiterplatte verbunden.

3. Die faltbare elektronische Vorrichtung nach Anspruch 1 oder 2, wobei die Drehwellenbaugruppe eine Drehwelle (131), einen ersten Schwenkarm (132) und einen zweiten Schwenkarm (133) umfasst; und
der erste Schwenkarm und der zweite Schwenkarm sind jeweils drehbar mit der Drehwelle verbunden, der erste Schwenkarm ist fest mit dem ersten Mittelrahmenteil verbunden, und der zweite Schwenkarm ist fest mit dem zweiten Mittelrahmenteil verbunden.

4. Die faltbare elektronische Vorrichtung nach Anspruch 3, wobei jede der mindestens einen Wellenabdeckbaugruppen eine Wellenabdeckung (191), ein erstes Befestigungselement (192) und zwei Koppelungselemente (193) umfasst;
zwei Führungsschlitze (1911) sind auf der Wellenabdeckung angeordnet, wobei ein Ende jedes Koppelungselements in dem Führungsschlitz angeordnet und verschiebbar mit dem Führungsschlitz verbunden ist;
zwei Drehhohlräume sind am ersten Befestigungselement angeordnet, und das andere Ende jedes Koppelungselements ist in dem Drehhohlraum angeordnet und drehbar mit dem Drehhohlraum verbunden; und
Die flexible Leiterplatte ist fest mit der Wellenabdeckung verbunden, der erste Befestiger ist fest mit der Drehwelle verbunden, eines der beiden Verbindungselemente ist fest mit dem ersten Schwenkarm verbunden und das andere der beiden Verbindungselemente ist fest mit dem zweiten Schwenkarm verbunden.

5. Die faltbare elektronische Vorrichtung nach Anspruch 4, wobei die Wellenabdeckung einen Wellenabdeckungskörper (1912) und einen zweiten Befestiger (1913), der fest mit dem Wellenabdeckungskörper verbunden ist, umfasst; und
Die flexible Leiterplatte ist fest mit dem Wellenabdeckungskörper verbunden, und die Führungsschiene befindet sich am zweiten Befestiger.

6. Die faltbare elektronische Vorrichtung nach Anspruch 5, wobei die flexible Leiterplatte fest an einer dem Drehwellenaggregat abgewandten Seite des Wellenabdeckungskörpers angebracht ist.

7. Die faltbare elektronische Vorrichtung nach einem der Ansprüche 4 bis 6, wobei das Verbindungselement einen Drehteil (1931) und einen mit dem Drehteil verbundenen Schiebeteil (1932) umfasst;
Der Drehteil befindet sich in der Drehkammer und ist drehbar mit der Drehkammer verbunden; und
Der Schiebeteil befindet sich in der Führungsschiene und ist verschiebbar mit der Führungsschiene verbunden.

8. Die faltbare elektronische Vorrichtung nach einem der Ansprüche 4 bis 7, wobei die Führungsschiene eine D-förmige Nut ist.

9. Die faltbare elektronische Vorrichtung nach einem der Ansprüche 4 bis 8, wobei die Zentralachse des Drehteils in Axialrichtung des Verbindungselements nicht mit der Zentralachse des Schiebeteils in Axialrichtung des Verbindungselements übereinstimmt.

10. Die faltbare elektronische Vorrichtung nach Anspruch 9, wobei die Größe des Drehteils in radialer Richtung des Verbindungselements kleiner ist als die Größe des Schiebeteils in radialer Richtung des Verbindungselements.

11. Die faltbare elektronische Vorrichtung nach einem der Ansprüche 4 bis 10, wobei sich im Vorgang, in dem der erste Schwenkarm und der zweite Schwenkarm relativ zueinander gefaltet werden, die Wellenabdeckungseinheit in Richtung der Dicke der faltbaren elektronischen Vorrichtung auf die Drehwelle zu bewegt; und
Im Vorgang, in dem der erste Schwenkarm und der zweite Schwenkarm relativ zueinander entfaltet werden, bewegt sich die Wellenabdeckungseinheit in Richtung der Dicke der faltbaren elektronischen Vorrichtung von der Drehwelle weg.

12. Die faltbare elektronische Vorrichtung nach Anspruch 11, wobei bei einer Relativentfaltung des ersten und zweiten Schwenkarms in gleicher Ebene der Abstand zwischen der Wellenabdeckungseinheit und der Drehwelle ein erster vorgegebener Abstand ist;
Wenn der erste und der zweite Schwenkarm relativ zueinander auf derselben Ebene zusammengeklappt sind, beträgt der Abstand zwischen der Wellenabdeckungseinheit und der Drehwelle eine zweite voreingestellte Distanz; und
Der Unterschied zwischen der ersten voreingestellten Distanz und der zweiten voreingestellten Distanz beträgt 1 mm bis 1,7 mm.

## Revendications

1. Dispositif électronique pliable (100), comprenant au moins les éléments suivants :
une première partie de cadre intermédiaire (110), une seconde partie de cadre intermédiaire (120), et un ensemble arbre rotatif (130), dans lequel
la première partie de cadre intermédiaire et la seconde partie de cadre intermédiaire sont reliées de manière rotative l'une à l'autre par l'ensemble arbre rotatif ;
le dispositif électronique pliable comprend en outre une carte de circuit flexible (180) et au moins un ensemble capot d'axe (190), et ledit ou lesdits ensembles capot d'axe sont raccordés de façon rotative à l'ensemble arbre rotatif ; et
la carte de circuit flexible est fixée à au moins un ensemble capot d'axe, **caractérisé en ce qu'**au cours du processus de pliage ou de dépliage entre la première et la seconde partie de cadre intermédiaire, ledit ou lesdits ensembles capot d'axe se déplacent en va-et-vient par rapport à l'ensemble arbre rotatif selon la direction de l'épaisseur du dispositif électronique pliable.

2. Dispositif électronique pliable selon la revendication 1, comprenant aussi une première carte de circuit (160) et une seconde carte de circuit (170), dans lequel
la première carte de circuit est située sur la première partie de cadre intermédiaire, la seconde carte de circuit est située sur la seconde partie de cadre intermédiaire, une extrémité de la carte de circuit flexible est connectée à la première carte de circuit, et l'autre extrémité de la carte de circuit flexible est connectée à la seconde carte de circuit après avoir traversé l'ensemble arbre rotatif.

3. Dispositif électronique pliable selon la revendication 1 ou 2, dans lequel l'ensemble arbre rotatif comprend un arbre rotatif (131), un premier bras oscillant (132), et un second bras oscillant (133) ; et
le premier bras oscillant et le second bras oscillant sont chacun reliés de manière rotative à l'arbre rotatif, le premier bras oscillant est fixé à la première partie de cadre intermédiaire, et le second bras oscillant est fixé à la seconde partie de cadre intermédiaire.

4. Dispositif électronique pliable selon la revendication 3, dans lequel chacun desdits ensembles capot d'axe comprend un capot d'axe (191), un premier dispositif de fixation (192), et deux éléments de liaison (193) ;
deux rainures coulissantes (1911) sont disposées sur le capot d'axe, et une extrémité de chaque élément de liaison est située dans la rainure coulissante et y est raccordée de façon coulissante ;
deux cavités rotatives sont disposées sur le premier dispositif de fixation, et l'autre extrémité de chaque élément de liaison est située dans la cavité rotative et y est raccordée de façon rotative ; et
le circuit imprimé flexible est fixé de manière permanente au couvercle d'arbre, le premier dispositif de fixation est fixé de manière permanente à l'arbre rotatif, l'un des deux éléments de liaison est fixé de manière permanente au premier bras oscillant, et l'autre des deux éléments de liaison est fixé de manière permanente au second bras oscillant.

5. Dispositif électronique pliable selon la revendication 4, dans lequel le couvercle d'arbre comprend un corps de couvercle d'arbre (1912) et un second dispositif de fixation (1913) fixé de manière permanente au corps de couvercle d'arbre ; et
le circuit imprimé flexible est fixé de manière permanente au corps du couvercle d'arbre, et la rainure coulissante se trouve sur le second dispositif de fixation.

6. Dispositif électronique pliable selon la revendication 5, dans lequel le circuit imprimé flexible est fixé de manière permanente sur un côté du corps du couvercle d'arbre, ce côté étant opposé à l'ensemble de l'arbre rotatif.

7. Dispositif électronique pliable selon l'une quelconque des revendications 4 à 6, dans lequel l'élément de liaison comprend une partie rotative (1931) et une partie coulissante (1932) reliée à la partie rotative ;
la partie rotative est située dans la cavité rotative et est reliée de façon pivotante à la cavité rotative ; et
la partie coulissante est située dans la rainure coulissante et est reliée de manière coulissante à la rainure coulissante.

8. Dispositif électronique pliable selon l'une quelconque des revendications 4 à 7, dans lequel la rainure coulissante est une rainure en forme de D.

9. Dispositif électronique pliable selon l'une quelconque des revendications 4 à 8, dans lequel l'axe central de la partie rotative dans la direction axiale de l'élément de liaison ne coïncide pas avec l'axe central de la partie coulissante dans la direction axiale de l'élément de liaison.

10. Dispositif électronique pliable selon la revendication 9, dans lequel la taille de la partie rotative dans la direction radiale de l'élément de liaison est inférieure à celle de la partie coulissante dans la direction radiale de l'élément de liaison.

11. Dispositif électronique pliable selon l'une quelconque des revendications 4 à 10, dans lequel, lors du pliage du premier bras oscillant et du second bras oscillant l'un par rapport à l'autre, l'ensemble du couvercle d'arbre se déplace vers l'arbre rotatif dans la direction de l'épaisseur du dispositif électronique pliable ; et
lors du déploiement du premier bras oscillant et du second bras oscillant l'un par rapport à l'autre, l'ensemble du couvercle d'arbre s'éloigne de l'arbre rotatif dans la direction de l'épaisseur du dispositif électronique pliable.

12. Dispositif électronique pliable selon la revendication 11, dans lequel, lorsque le premier bras oscillant et le second bras oscillant sont déployés sur un même plan l'un par rapport à l'autre, la distance entre l'ensemble du couvercle d'arbre et l'arbre rotatif est une première valeur de distance prédéfinie ;
lorsque le premier bras oscillant et le deuxième bras oscillant sont repliés sur un même plan l'un par rapport à l'autre, la distance entre l'ensemble du couvercle d'arbre et l'arbre rotatif correspond à une deuxième distance prédéfinie ; et
une différence entre la première distance prédéfinie et la deuxième distance prédéfinie est de 1 mm à 1,7 mm.
